# EUROPÄISCHE PATENTSCHRIFT

(11) **EP 2 845 451 B1**
(45) Veröffentlichungstag und Bekanntmachung des Hinweises auf die Patenterteilung: **23.08.2017**
(21) Anmeldenummer: 13726436.2
(22) Anmeldetag: 02.05.2013
(51) Int. Cl.: H05H 1/36, H05H 1/44

(54) **PLASMAERZEUGUNGSVORRICHTUNG**
PLASMA GENERATION DEVICE
DISPOSITIF DE PRODUCTION DE PLASMA

(30) Priorität: 04.05.2012 DE 102012103938
(43) Veröffentlichungstag der Anmeldung: 11.03.2015
(73) Patentinhaber: Relyon Plasma GmbH, 93057 Regensburg (DE); EPCOS AG, 81669 München (DE)
(72) Erfinder: NETTESHEIM, Stefan, 93051 Regensburg (DE); KÜGERL, Georg, 8552 Eibiswald (AT); PUFF, Markus, 8010 Graz (AT)
(74) Vertreter: Reichert & Lindner Partnerschaft Patentanwälte
(86) Internationale Anmeldenummer: PCT/EP2013/059150
(87) Internationale Veröffentlichungsnummer: WO 2013/164406

(56) Entgegenhaltungen:
- EP-A2- 1 441 578
- WO-A1-2009/060213
- WO-A1-2009/062846

## Beschreibung

Die Erfindung betrifft eine Plasmaerzeugungsvorrichtung zur Erzeugung eines Plasmas mit wenigstens zwei Plasmamodulen. Jedes dieser Plasmamodule umfasst mindestens einen Gaseinlass für ein Prozessgas, eine Entladungseinrichtung zur Erzeugung des Plasmas aus dem Prozessgas und einen Plasmaauslass.

Plasmabehandlungen sind breit einsetzbar, zum Beispiel zum Aktivieren von Oberflächen zur besseren Klebehaftung, zur Sterilisation von Nahrungsmitteln, Wunden oder chirurgischem Besteck, zur Beschichtung oder auch zur in situ-Erzeugung von Ozon aus Precursorgasen. Vor allem das industrielle Anwendungsfeld der Plasmabehandlung erweitert sich um immer neue Spezialanwendungen. Zunehmend werden nichtplasmabasierte Standardprozesse durch Plasmaprozesse ersetzt. Von Anwendung zu Anwendung variieren die Anforderungen an das Plasma stark bezüglich der Plasmaeigenschaften (wie Plasmadruck, Plasmaleistung, Plasmaleistungsdichte, Plasmatemperaturen oder Ionisierungsgrad) oder der Auslegung der Plasmaerzeuger. Aus Gründen der Kosteneffizienz gewinnen standardisierbare und gleichzeitig variabel einsetzbare Konzepte für Plasmaerzeuger an Bedeutung. Wünschenswerte Eigenschaften sind dabei insbesondere eine kompakte, flexibel einsetzbare Bauform der Plasmaerzeuger, der Niederspannungsbetrieb um Atmosphärendruck und eine geringere Abwärme bei der Plasmaerzeugung. Plasmaquellen mit einer düsenartigen Konstruktion können Plasmastrahlen mit relativ hoher Ionendichte erzeugen. Allerdings ist so eine breite flächige Bearbeitung von Bauteilen nur durch Rastern des Plasmastrahls möglich. Bei gegebener Leitungsdichte des Plasmaerzeugers steigt damit die Bearbeitungszeit mit der zu bearbeitenden Fläche an. Werden mehrere Plasmaerzeuger gleichzeitig eingesetzt, steigt der Aufwand für die elektrische Verdrahtung und die Versorgung mit Prozessgas.

Aus der deutschen Offenlegungsschrift DE 37 33 492 A1 ist eine Vorrichtung mit einem Plasmaerzeuger bekannt, der elektrisch versorgt wird. Zwei Elektroden bilden einen Luftspalt, durch den hindurch ein Gasstrom geleitet wird. Mit Hilfe einer Koronaentladung wird das durchströmende Gas ionisiert.

Die britische Patentanmeldung GB 1 412 300 A offenbart einen Lichtbogengenerator mit einer Vielzahl von Elektroden, an die eine zumindest dreiphasige Wechselspannung angelegt wird, um aus einem Gas einen Plasmastrahl zu zünden und auf ein auf der elektrischen Erde der Spannungsquelle liegendes Werkstück zu richten. Gemäß einer Ausführungsform ragen drei Elektroden in ein gasdurchflossenes Gehäuse mit Düse und sind über je eine Steuerleitung an einen Stromregler angeschlossen. Gemäß einer anderen Ausführungsform sind Gruppen von je drei Elektroden mit je einem Stromregler verbunden, die ihrerseits mit einer Spannungsquelle verbunden sind.

Die deutsche Offenlegungsschrift DE 10 2007 024 090 A1 schlägt eine Vorrichtung zur Plasmabehandlung vor, die mehrere Plasmaerzeuger umfasst. In einem als Außenelektrode fungierenden Gehäuse eines jeden Plasmaerzeugers ist eine Düsenöffnung ausgebildet sowie eine Innenelektrode aufgenommen. Über je eine Abzweigung einer gemeinsamen Gaszuleitung der Vorrichtung wird jeder Plasmaquelle ein Gasstrom zugeführt.

Piezoelektrische Hochspannungserzeuger finden als Elektroden Einsatz in Plasmaquellen und sind geeignet, aus Gasen nahe Atmosphärendruck Plasmen zu zünden, wie beispielsweise aus der DE 10 2005 032 890 A1 bekannt ist. Sie sind jedoch in ihrer Leistung begrenzt durch die thermischen Verluste sowie durch ihre elektromechanische Belastungsgrenze. Der Leistungsbegrenzung durch die thermischen Verluste kann zwar durch eine effiziente Abführung der entstehenden Wärme an die Umgebung entgegengewirkt werden, jedoch bleibt weiterhin ihre Gesamtleistung begrenzt. Damit geht eine im Vergleich zu anderen Typen von Plasmaerzeugern geringe Plasmaleistung einher. Zudem ist ein Clustern mehrerer solcher Plasmaerzeuger möglich, mit dem eine ausreichend hohe Plasmaleistungsdichte über größere Flächen erzielt werden kann.

Mit einer düsenartigen Konstruktion kann die Plasmaleistungsdichte lokal erhöht werden, indem ein Sekundärplasmastrahl mit relativ hoher Ionendichte erzeugt wird. Allerdings ist so eine großflächige Behandlung einer Oberfläche mit einem Plasmastrahl nur durch ein serielles Abrastern der Oberfläche mit dem Plasmastrahl möglich. Abgesehen von der mechanisch aufwändigen zusätzlichen Rastervorrichtung verlängert sich damit die Bearbeitungszeit mit der zu bearbeitenden Oberfläche erheblich. Das in der DE 10 2005 032 890 A1 beschriebene Clustern ermöglicht nur eine eingeschränkte und wenig variable Konfigurierbarkeit des Systems. Zudem ist die elektrische Verdrahtung und Versorgung mit Prozessgas der einzelnen Plasmaerzeuger aufwändig und teuer.

Die Veröffentlichung WO 2009/060213 A1 der internationalen Patentanmeldung PCT/GB2008/003763 offenbart ein System zur Sterilisierung von Gewebeoberflächen und dergleichen mittels Plasma. Dabei wird atmosphärisches Niedertemperaturplasma durch Mikrowellen aus einem Gas erzeugt. Überschüssiges Gas kann durch eine Abführung von der Oberfläche entfernt werden. In dem System können mehrere Plasmaemitter zusammenwirken.

Die Veröffentlichung WO 2009/062846 A1 der internationalen Patentanmeldung PCT/EP2008/064621 betrifft ein Verfahren zur Zündung und Aufrechterhaltung eines Plasmas in einem Gasraum und eine entsprechende, als Resonator ausgebildete Einrichtung. Dabei wird ein piezoelektrisches Material verwendet.

Es ist Aufgabe der Erfindung, eine Plasmaerzeugungsvorrichtung zu schaffen, die einfach zu montieren, umzurüsten, zu warten und zu betreiben ist.

Diese Aufgabe wird durch eine Plasmaerzeugungsvorrichtung nach Anspruch 1 gelöst.

Die erfindungsgemäße Plasmaerzeugungsvorrichtung umfasst mindestens zwei Plasmamodule zur Erzeugung eines Plasmas. Dieses kann eigenständig oder im Verbund mit weiteren baugleichen oder ähnlichen Plasmamodulen betrieben werden. In einem Modulgehäuse jedes Plasmamoduls sind mindestens ein Gaseinlass zur Zuführung eines Prozessgases und mindestens ein Gasauslass für einen Teil des insbesondere nicht plasmafizierten Prozessgases ausgebildet. Die Gaseinlässe und Gasauslässe stehen über einem im Modulgehäuse ausgebildeten Gasversorgungskanal miteinander in fluider Verbindung. Im Modulgehäuse ist eine Entladungseinrichtung zur Erzeugung des Plasmas aus dem Prozessgas aufgenommenen.

Die Entladungseinrichtung des Plasmamoduls weist einen über eine Steuerleitung steuerbaren elektrischen Treiberbaustein und einen piezoelektrischen Transformator auf. Der Treiberbaustein ist über mindestens zwei elektrische Leitungen mit der Primärseite des piezoelektrischen Transformators verbunden. Ein piezoelektrischen Transformator kann in kompakter Bauform ausgestaltet sein und mit relativ niedrigen primärseitigen Eingangsspannungen (z.B. 24 V AC) an seiner Sekundärseite hinreichend hohe Spannungen zur Zündung eines Plasmas aus dem Gas im Normaldruckbereich erzeugen. Der Plasmaauslass des Plasmamoduls kann als Düse zur Erzeugung eines gerichteten Plasmastrahls ausgebildet sein. Insbesondere kann die Sekundärseite des piezoelektrischen Transformators in dieser Düse angeordnet sein.

Dem Modulgehäuse des Plasmamoduls ist ein Steuermodul zugeordnet. Das Steuermodul kann als integraler Bestandteil des Modulgehäuses ausgebildet sein. Ebenso ist es denkbar, dass das Steuermodul ein mit dem Modulgehäuse lösbar verbundenes Bauteil ist. Das Steuermodul ist über eine Steuerleitung und mindestens eine Spannungsleitung mit der Entladungseinrichtung elektrisch verbunden. Das Steuermodul trägt für die mindestens eine Spannungsleitung und die Steuerleitung jeweils mindestens eine Ausgangsschnittstelle und mindestens eine Eingangsschnittstelle.

Das Steuermodul hat eine Steuerleitung und mindestens eine Spannungsleitung, die mit dem Treiberbaustein elektrisch verbunden sind. Ferner besitzt das Steuermodul mindestens eine Ausgangsschnittstelle und eine mindestens eine Eingangsschnittstelle.

Die erfindungsgemäße Plasmaerzeugungsvorrichtung zur Erzeugung eines Plasmas umfasst wenigstens zwei Plasmamodule. Jedes Plasmamodul weist ein Modulgehäuse mit mindestens einem Gaseinlass zur Zuführung eines Prozessgases und einem Plasmaauslass auf. Eine Entladungseinrichtung zur Erzeugung des Plasmas aus dem Prozessgas ist im Modulgehäuse vorgesehen. Ferner ist im Modulgehäuse eines jeden Plasmamoduls mindestens ein Gasauslass für einen Teil des Prozessgases ausgebildet. Die Plasmaerzeugungsvorrichtung ist so ausgestaltet, dass der mindestens eine Gasauslass zumindest eines Plasmamoduls über eine Abstandsbrücke in je einen Gaseinlass eines anderen Plasmamoduls mündet. Dadurch entsteht ein übergeordneter Gasversorgungskanal, über den alle Plasmamodule der Plasmaerzeugungsvorrichtung miteinander in fluider Verbindung stehen, so dass beispielsweise die gesamte Plasmaerzeugungsvorrichtung mit einer einzigen externen Gasversorgungsleitung mit Prozessgas gespeist werden kann.

Die Entladungseinrichtung der Plasmaerzeugungsvorrichtung weist insbesondere einen steuerbaren elektrischen Treiberbaustein auf, der zur Erzeugung des Plasmas mittels Entladungen im Normaldruckbereich elektrisch mit einem piezoelektrischen Transformator verbunden ist.

In der erfindungsgemäßen Plasmaerzeugungsvorrichtung umfasst jedes Plasmamodul ein Steuermodul. Jedes Steuermodul ist über eine Steuerleitung und mindestens eine Spannungsleitung mit der Entladungseinrichtung des jeweiligen Plasmamoduls elektrisch verbunden. Für jede seiner Spannungsleitungen und für seine Steuerleitung trägt das Steuermodul jeweils mindestens eine Eingangsschnittstelle und mindestens eine Ausgangsschnittstelle. Die Plasmamodule sind derart miteinander verbunden, dass mindestens eine Ausgangsschnittstelle des Steuermoduls jedes ersten Plasmamoduls mit je mindestens einer Eingangsschnittstelle des Steuermoduls eines verbundenen Plasmamoduls elektrisch verbunden ist. Dadurch sind die Steuerleitungen derart elektrisch verbunden, dass sie einen gemeinsamen Steuerbus zur Steuerung aller bzw. jedes der gekoppelten Plasmamodule bilden.

Die Plasmamodule der Plasmaerzeugungsvorrichtung sind über ihre Steuermodule elektrisch miteinander derart verbunden, dass gleichzeitig mindestens ein Gaseinlass eines Plasmamoduls mit einem Gasauslass eines verbundenen Plasmamoduls in fluider Verbindung steht.

Die Plasmamodule sind dabei mittelbar über eine Anordnung aus Abstandsbrücken miteinander verbunden. Eine erfindungsgemäße Abstandsbrücke besitzt einen Konnektor und einen Gasversorgungskanal mit mindestens einen Gaseinlass und einem Gasauslass. Sie verbindet mindestens zwei aufeinanderfolgende Plasmamodule derart miteinander, dass ihr Konnektor die Steuermodule der Plasmamodule jeweils elektrisch verbindet, und dass mindestens ein Gasauslass des Plasmamoduls mit einem Gaseinlass der Abstandsbrücke und ein Gasauslass der Abstandsbrücke mit einem Gaseinlass eines weiteren Plasmamoduls in fluider Verbindung steht.

Die Kopplung der Plasmamodule untereinander ist insbesondere lösbar ausgestaltet und beruht auf Kraftschluss oder Formschluss. Die Plasmamodule und die Abstandsbrücke sind steckbar miteinander verbunden, so dass eine form- und/oder kraftschlüssige Verbindung entsteht. Gemäß einer bevorzugten Ausführungsform der Erfindung beruht die Kopplung auf einer Steckverbindung. Die Steckverbindung kann zusätzlich durch Befestigungsmittel wie Rasthaken, Schrauben, Bolzen oder mit Kabelbindern verbundene Ösen gesichert sein. Beispielsweise können die Gaseinlässe und Gasauslässe als kraftschlüssig ineinandergreifende Gegenstücke eines Steckerpaars ausgestaltet sein, so dass eine gasdichte Kopplung entsteht. Zur zusätzlichen Abdichtung der Steckverbindung können Dichtmittel wie Dichtringe oder Dichtfette vorgesehen sein. Desgleichen können auch die Eingangsschnittstellen und Ausgangsschnittstellen der Steuermodule als kraftschlüssig ineinandergreifende Gegenstücke eines Steckerpaares ausgebildet sein.

Die Plasmaerzeugungsvorrichtung kann so ausgestaltet werden, dass wenigstens ein Gaseinlass und/oder ein Gasauslass eines Plasmamoduls nicht mit einem Gasauslass respektive Gaseinlass eines weiteren Plasmamoduls oder einer Abstandsbrücke verbunden ist.

Gemäß einer Ausführungsform der Erfindung können diese freien Gaseinlässe und Gasauslässe offen bleiben, so dass die Plasmaerzeugungsvorrichtung, falls erforderlich, gasgekühlt wird. Gemäß einer anderen Ausführungsform sind die freien Gaseinlässe und Gasauslässe mit Verschlusselementen insbesondere gasdicht verschlossen. Verschlusselemente können beispielsweise Blindflansche mit Dichtelementen sein. Sie können auch von einem Gehäuse der Plasmaerzeugungsvorrichtung, das die Plasmamodule aufnimmt, verschlossen sein. Insbesondere können alle freien Gaseinlässe oder Gasauslässe mit Verschlusselementen verschlossen werden, so dass Gas nur über die Plasmaauslässe aus den Modulgehäusen der Plasmamodule ausströmen kann.

Die Plasmamodule sind über Abstandsbrücken miteinander verbunden. Erfindungsgemäß weist jede Abstandsbrücke einen Konnektor auf, so dass die Steuermodule der Plasmamodule elektrisch miteinander verbunden sind. Zusätzlich weist jede Abstandsbrücke mindestens einen Gaseinlass und einen Gasauslass auf. Mindestens ein Gaseinlass und mindestens ein Gasauslass jeder Abstandsbrücke münden erfindungsgemäß in einen Gasauslass respektive Gaseinlass verbundener Plasmamodule oder verbundener weiterer Abstandsbrücken.

Die verbundenen Plasmamodule der Plasmaerzeugungsvorrichtung können in einer ein-, zwei- oder dreidimensionalen Art angeordnet sein. Beispielsweise können die Plasmamodule und/oder Abstandsbrücken der Plasmaerzeugungsvorrichtung in einer eindimensionalen Anordnung, wie einer linearen Reihe oder einer geschlossenen Kontur wie einer Kreislinie, oder einer zweidimensionalen Matrix miteinander verbunden sein. Soll zum Beispiel ein Werkstück mit einem Tiefenprofil, wie etwa eine vertieft abgesetzte Fuge, plasmabehandelt werden, so können beispielsweise Plasmamodule seitlich und von unten an einer Abstandsbrücke verbunden werden. Die Erfindung bietet den besonderen Vorteil, dass beliebige ein-, zwei- oder dreidimensionale Konturen durch eine Matrix aus Plasmamodulen abgebildet werden können, so dass die Plasmaerzeugungsvorrichtung lediglich über einem zu plasmabehandelnden Werkstück positioniert werden muss. Dies ist oftmals schneller, einfacher und kostengünstiger als eine Kontur oder Fläche auf dem Werkstück durch einen Roboter oder einen Bediener abzurastern. Bei gegebener Leistungsdichte des Plasmaerzeugers steigt damit die Bearbeitungszeit mit der zu bearbeitenden Fläche an. Teilbereiche einer Kontur oder Fläche können von der Plasmabehandlung entweder durch Verwendung entsprechend positionierter Abstandsbrücken oder durch selektive Ansteuerung der Plasmamodule ausgespart werden.

Gemäß einer besonderen Ausführungsform der Erfindung können die Plasmamodule und Abstandsbrücken der Plasmaerzeugungsvorrichtung an einer gemeinsamen Montageleiste angebracht sein. Vorteilhafterweise ist die Anbringung lösbar, z.B. eine Steckverbindung. Die Montageleiste kann beispielsweise als Klemmschiene, Pneumatikschiene oder Hutschiene ausgebildet sein.

Gemäß einer besonderen Ausführungsform der erfindungsgemäßen Plasmaerzeugungsvorrichtung können alle ihre Plasmamodule von einem gemeinsamen Gehäuse umgeben sein. Dabei kann insbesondere der Plasmaauslass der Plasmamodule aus dem Gehäuse über einen gemeinsamen Plasmaauslass ausmünden. Ebenso kann der Plasmaauslass in ein verbundenes Plasmamodul einmünden.

Die vorgeschlagene Plasmaerzeugungsvorrichtung hat den Vorteil, dass sie auf einfache Weise modular erweitert und umgerüstet werden kann. Die Versorgungsspannung liegt im Niederspannungsbereich (z.B. 24V Bus). Weiterhin kann die Kühlung der Bauteile durch das Prozessgas erreicht werden, da die Plasmamodule eine große gasumströmte Gesamtfläche haben. Weiterhin sind eine einfache Montage, Wartung und ein einfacher Austausch der Einzelkomponenten möglich. Zudem kann eine Einzelansteuerung der Plasmamodule über einen Steuerbus erreicht werden.

Somit kann die Leistung der Plasmaerzeugungsvorrichtung modular erweitert werden, wobei gleichzeitig eine unwirtschaftliche Vielfalt in den Grundbauteilen weitgehend vermieden wird.

Der Plasmaerzeugungsvorrichtung sind typischerweise Peripheriegeräte wie Spannungsquellen, Gasversorgungseinheiten wie Gebläse oder Gastanks mit Druckregulatoren (z.B. Mass Flow Controllern), Controller zur Ansteuerung der Plasmaquellen über die Steuerleitungen, Tragegerüste oder Werkstückhalter zugeordnet. Die Peripheriegeräte sind über entsprechende Zuleitungen mit der Plasmaerzeugungsvorrichtung verbindbar. Diese Zuleitungen können vorteilhafterweise mit erfindungsgemäßen Steuermodulen, Eingangsschnittstellen, Ausgangsschnittstellen bzw. Gaseinlässen und Gasauslässen versehen sein. Eine erfindungsgemäße Plasmaerzeugungsvorrichtung kann ihrerseits ein Modul in einem System aus Plasmaerzeugungsvorrichtungen darstellen.

Damit in allen Plasmamodulen der Plasmaerzeugungsvorrichtung kontrollierte und homogene Plasmabedingungen herrschen, müssen die dynamischen und statischen Druckverhältnisse in den Plasmamodulen dort, wo aus dem Prozessgas ein Plasma gezündet wird, homogen sein. Dies erfordert einen homogenen Druck bzw. Staudruck im übergeordneten Gasversorgungskanal. Der Staudruck ist hinreichend homogen, wenn die Summe der freien Querschnittsflächen der Plasmaauslässe aller Plasmamodule klein gegen die freie Querschnittsflächen ihres übergeordneten Gasversorgungskanals ist. Diese Bedingung begrenzt die Anzahl der z.B. miteinander in Reihe verschaltbaren Plasmamodule. Die "freie" Querschnittsfläche bezeichnet hier nur die Fläche, durch die Gas strömen kann, aus der also Flussimpedanzen herausgerechnet sind. Eine Flussimpedanz kann beispielsweise eine im Plasmaauslass angeordnete Elektrode darstellen. Zur Erzielung homogener Plasmabedingungen in den Plasmamodulen ist es ebenfalls vorteilhaft, die Plasmamodule mit möglichst geringen Gasströmungsgeschwindigkeiten (z.B. bei Reynoldszahlen unter 1000) und laminar zu speisen und bei der Ausgestaltung der Modulgehäuse oder des Gehäuses der Plasmaerzeugungseinrichtungen Flussimpedanzen oder Turbulatoren zu vermeiden.

Die Steuerleitung kann auch als Datenleitung fungieren, um den Plasmabehandlungsprozess durch einen elektronischen Datensatz zu protokollieren und z.B. nicht flüchtig in einem angeschlossenen Speichermedium zu sichern. Dies erhöht die Nachvollziehbarkeit, z.B. welches Werkstück wann welcher Plasmabehandlung unterzogen wurde, und trägt somit zur Prozesssicherheit bei.

Weitere Vorteile und vorteilhafte Ausgestaltungen der Erfindung sind Gegenstand der nachfolgenden Figuren sowie deren Beschreibungsteile. Gleiche und gleichwirkende Merkmale sind mit demselben Bezugszeichen gekennzeichnet.

Es zeigen im Einzelnen:
- **Figur 1**: eine schematische Darstellung eines Plasmamoduls, wie es bei der erfindungsgemäßen Plasmaerzeugungsvorrichtung eingesetzt werden kann;
- **Figur 2**: eine schematische Darstellung einer Plasmaerzeugungsvorrichtung aus in einer Reihe gekoppelten Plasmamodulen nach Figur 1;
- **Figur 3A**: eine schematische Darstellung einer Ausführungsform der erfindungsgemäßen Abstandsbrücke;
- **Figur 3B**: eine schematische Darstellung einer weiteren Ausführungsform der erfindungsgemäßen Abstandsbrücke;
- **Figur 4**: eine schematische Darstellung einer Plasmaerzeugungsvorrichtung bestehend aus Abstandsbrücken nach Figur 3A und Plasmamodulen nach Figur 1;
- **Figur 5**: eine schematische Darstellung einer Plasmaerzeugungsvorrichtung bestehend aus Abstandsbrücken nach Figur 3B und Plasmamodulen nach Figur 1;
- **Figur 6**: eine schematische Darstellung einer Plasmaerzeugungsvorrichtung in einer Ausgestaltungsform mit einem gemeinsamen Gehäuse;
- **Figur 7A**: eine schematische Darstellung eines Plasmamoduls mit dreieckigem Querschnittsprofil;
- **Figur 7B**: eine schematische Darstellung eines Plasmamoduls mit viereckigem Querschnittsprofil;
- **Figur 7C**: eine schematische Darstellung eines Plasmamoduls mit hexagonalem Querschnittsprofil;
- **Figur 8A**: eine schematische Darstellung einer Ausführungsform der Plasmaerzeugungsvorrichtung mit Montageleiste;
- **Figur 8B**: eine schematische Seitendarstellung einer weiteren Ausführungsform der Plasmaerzeugungsvorrichtung als dreidimensionale Matrix aus Plasmamodulen;
- **Figur 8C**: eine schematisch dargestellte Draufsicht einer weiteren Ausführungsform der Plasmaerzeugungsvorrichtung als zweidimensionale Matrix aus Plasmamodulen; und
- **Figur 8D**: eine schematisch dargestellte Draufsicht einer weiteren Ausführungsform der Plasmaerzeugungsvorrichtung aus entlang einer geschlossenen Kontur angeordneten Plasmamodulen.

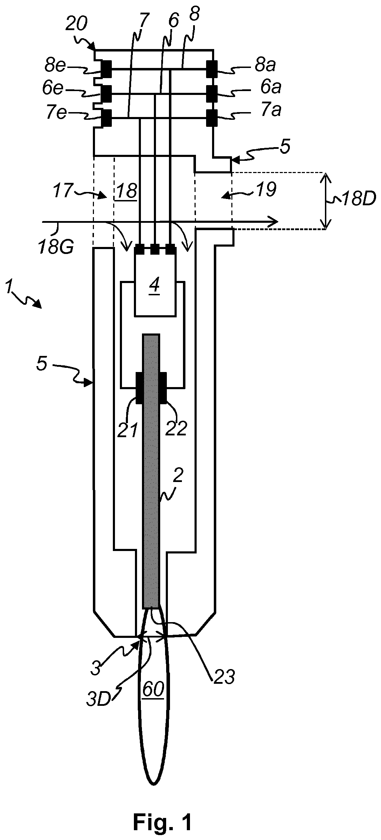

**In** **Figur 1** ist ein Plasmamodul 1, das ein Baustein einer erfindungsgemäßen Plasmaerzeugungsvorrichtung ist, schematisch dargestellt. Das Plasmamodul 1 weist ein Modulgehäuse 5 auf, in dem ein piezoelektrischer Transformator 2 und ein elektronischer Treiberbaustein 4 untergebracht sind. Ein piezoelektrischer Transformator besteht grundsätzlich aus einem piezoelektrischen Kristallstab mit zwei primärseitigen Elektroden 21, 22 und einer sekundärseitigen Elektrode 23. Durch Anlegen einer Wechselspannung an den primärseitigen Elektroden 21, 22 werden im piezoelektrischen Kristallstab mechanische Schwingungen induziert. Die Frequenz der mechanischen Schwingungen ist dabei wesentlich von der Geometrie des piezoelektrischen Kristallstabs, der als Resonator wirkt, und dem mechanischen Aufbau des piezoelektrischen Transformators 2 abhängig. Die mechanischen Schwingungen erzeugen durch den piezoelektrischen Effekt auf der Sekundärseite 23 des Kristallstabs eine Ausgangsspannung. Je nach Geometrie des Kristallstabs und Position der Elektroden 21, 22 am Kristall ist diese Ausgangsspannung höher oder niedriger als die Eingangsspannung. Aufgrund des hohen Transformationsverhältnisses können niedrige Eingangsspannungen leistungseffizient in hohe Ausgangsspannungen transformiert werden. Der Leistungsbereich eines einzelnen piezoelektrischen Transformators 2 ist vergleichsweise gering und liegt typischerweise im Bereich einiger Watt bis zu einigen 10 Watt, bei Resonanzfrequenzen um einige 10 kHz bis zu einigen 100 kHz. Damit lassen sich vergleichsweise einfach, hohe sinusförmige Wechselspannungen erzeugen, wie sie zur Erzeugung eines Plasmas 60 geeignet sind.

Durch einen Gaseinlass 17 kann ein Prozessgas 18G in das Modulgehäuse 5 einströmen. Ein Teil des Prozessgases strömt über einen Gasversorgungskanal 18 aus einem Gasauslass 19 wieder aus dem Modulgehäuse 5 heraus. Ein anderer Teil des Prozessgases strömt durch den Plasmaauslass 3 als gerichteter Plasmastrahl 60 aus. An der Sekundärseite 23 des piezoelektrischen Transformators 2 wird das Prozessgas 18G vor dem Ausströmen plasmafiziert. Der Plasmaauslass 3 kann als Düse ausgestaltet sein, oder es kann dem Plasmaauslass 3 eine Düse variabler Geometrie aufgesteckt werden.

Das Modulgehäuse 5 ist mit einem Steuermodul 20 versehen. Zwei Spannungsleitungen 6, 7 und eine Steuerleitung 8 des Steuermoduls 20 sind mit einem elektrischen Treiberbaustein 4 elektrisch leitend verbunden. Dieser ist mit den beiden primärseitigen Elektroden 21, 22 des piezoelektrischen Transformators 2 elektrisch verbunden. Die auf den piezoelektrischen Transformator 2 wirkendende elektrische Leistung wird gemäß den über die Steuerleitung 8 übermittelbaren Steuersignalen geregelt. Auf der Seite des Gaseinlasses 17 ist am Steuermodul 20 je eine Eingangsschnittstelle 6e, 7e, 8e für die beiden Spannungsleitungen 6, 7 und die Steuerleitung 8 ausgebildet. An der Seite des Gasauslasses 19 sind entsprechend korrespondierende Ausgangsschnittstellen 6a, 7a, 8a ausgebildet. Diese Eingangsschnittstellen 6e, 7e, 8e und Ausgangsschnittstellen 6a, 7a, 8a sind so am Modulgehäuse ausgestaltet, dass die Eingangsschnittstellen 6e, 7e, 8e eines Plasmamoduls 1 mit den Ausgangsschnittstellen 6a, 7a, 8a eines weiteren Plasmamoduls 1 koppelbar sind. Desgleichen sind die Gasauslässe 19 und die Gaseinlässe 17 derart am Modulgehäuse 5 der Plasmamodule 1 ausgestaltet, dass der Gaseinlass 17 eines Plasmamoduls 1 mit dem Gasauslass 19 eines weiteren Plasmamoduls 1 koppelbar ist.

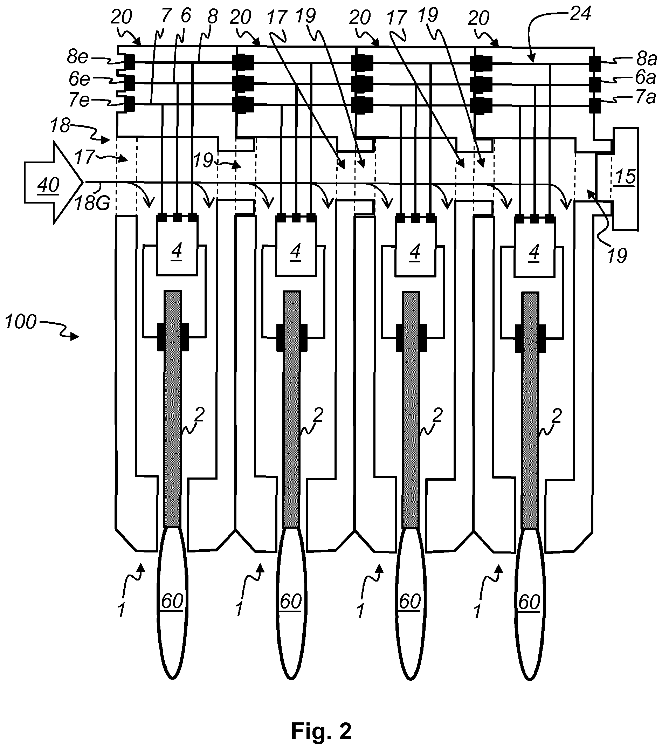

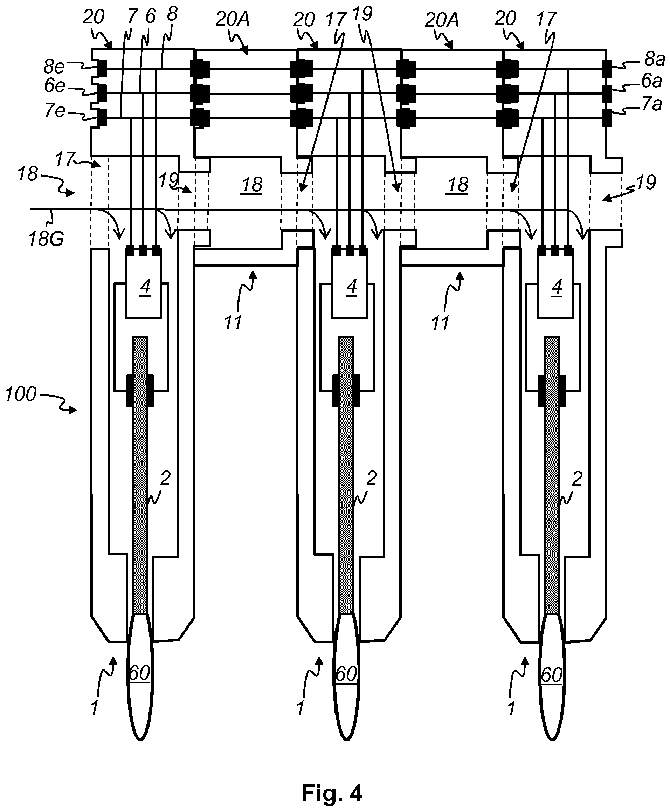

Das Plasmamodul 1 ist so auszugestalten, dass der Querschnitt 18D des Gasversorgungskanals 18 größer als der Querschnitt 3D des Plasmaauslasses 3 ist. Bei Plasmaerzeugungsvorrichtungen 100 (siehe z.B. Figur 2 oder Figur 4), die aus mehreren Plasmamodulen 1 bestehen, soll entsprechend der Querschnitt 18D des Gasversorgungskanals 18 größer als die Summe der Querschnitte 3D aller Plasmamodule 1 sein. Durch diese Bedingung wird sichergestellt, dass der Staudruck des Prozessgases 18G in jedem Plasmamodul 1 im Wesentlichen gleich ist, so dass über die Plasmamodule 1 homogene und kontrollierte Plasmabedingungen herrschen.

**Figur 2** zeigt schematisch eine Plasmaerzeugungsvorrichtung 100 in einer ersten beispielhaften Ausgestaltungform, die durch mehrere in einer horizontalen Reihe miteinander gekoppelte bzw. zusammengesteckte Plasmamodule 1 gebildet wird. Durch die Steckverbindung sind insbesondere auch die Steuermodule 20 und die Gaskanäle 18 aller in der Reihe benachbarten Plasmamodule 1 direkt miteinander gekoppelt. Dadurch sind die Spannungsleitungen 6, 7 der einzelnen Plasmamodule 1 zu übergeordneten Spannungsleitungen 6, 7, die Steuerleitungen 8 der einzelnen Plasmamodule 1 zu einer übergeordneten Steuerleitung 8 und die Gaskanäle 18 der einzelnen Plasmamodule 1 zu einem übergeordneten Plasmakanal 18 verbunden. Die verbundenen Steuerleitungen 8 der Steuermodule bilden einen Steuerbus 24, so dass jedes Plasmamodul 1 einzeln ansteuerbar ist.

Eine bevorzugt e Ausführungsform der Erfindung sieht vor, dass der Gaseinlass 17 und der Gasauslass 19 ineinandergreifende Gegenstücke einer Steckverbindung sind. Um die Gasdichtigkeit dieser Steckverbindung zu erhöhen, können zwischen einem Gaseinlass 17 und einem Gasauslass 19 geeignete Dichtungselemente (nicht dargestellt) vorgesehen werden.

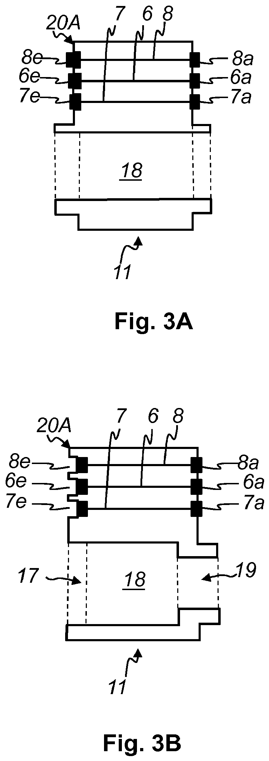

**Figur 3A und 3B** zeigen zwei Ausführungsformen der erfindungsgemäßen Abstandsbrücken 11. Die in Figur 3A einzeln dargestellte Abstandsbrücke 11 trägt erfindungsgemäß einen Konnektor 20A mit Spannungsleitungen 6, 7 und einer Steuerleitung 8. Die Spannungsleitungen 6, 7 und die Steuerleitung 8 tragen jeweils eine am Konnektor 20A angeordnete Eingangsschnittstellen 6e, 7e, 8e und Ausgangsschnittstelle 6a, 7a, 8a. Ferner trägt die Abstandsbrücke 11 einen Gaseinlass 17 und einen Gasauslass 19, die über einen Gasversorgungskanal 18 fluide verbunden sind.

Gemäß der in Figur 3A gezeigten Ausführungsform sind alle Gaseinlässe 17 und Gasauslässe 19 sowie alle Eingangsschnittstellen 6e, 7e, 8e und Ausgangsschnittstellen 6a, 7a, 8a der Abstandsbrücken und der Plasmamodule 1 "männlich" respektive "weiblich" ausgeprägt. Damit kann die Abstandsbrücke 11 in dieser Ausführungsform mit einem oder mehreren Plasmamodulen 1 gekoppelt werden. Die Abstandsbrücken 11 dieser Ausführungsform können also untereinander und/oder mit Plasmamodulen 1 versteckt werden.

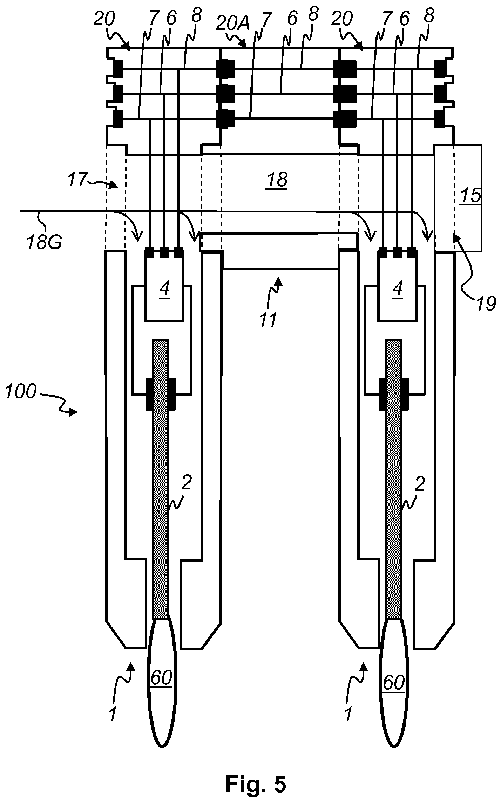

Gemäß der in Figur 3B gezeigten weiteren Ausführungsform der Abstandsbrücken 11 sind alle Gaseinlässe 17 und Gasauslässe 19 sowie alle Eingangsschnittstellen 6e, 7e, 8e und Ausgangsschnittstellen 6a, 7a, 8a der Abstandsbrücken "männlich" und die der Plasmamodule 1 "weiblich" (siehe Fig. 5) ausgeprägt.

**Figur 4** zeigt eine schematische Darstellung einer Ausführungsform der erfindungsgemäßen Plasmaerzeugungsvorrichtung 100. Sie besteht aus Abstandsbrücken 11 nach Figur 3A und Plasmamodulen 1 nach Figur 1. Während in dem in Figur 2 dargestellten Beispiel die Plasmaerzeugungsvorrichtung 100 durch eine unmittelbare Steckverbindung mehrerer Plasmamodule 1 entsteht, sind in Figur 4 die Plasmamodule 1 mittelbar über Abstandsbrücken 11 verbunden. Innerhalb einer erfindungsgemäßen Plasmaerzeugungsvorrichtung 100 sind Plasmamodule 1 mittelbar über Abstandsbrücken 11 gekoppelt. Um größere Distanzen zwischen Plasmamodulen 1 zu überbrücken, können auch zwei oder mehr Abstandsbrücken 11 zwischengekoppelt werden.

**Figur 5** zeigt schematisch eine weitere Ausführungsform der erfindungsgemäßen Plasmaerzeugungsvorrichtung 100. Sie umfasst Abstandsbrücken 11 nach Figur 3B und Plasmamodule 1, deren Gaseinlässe 17, Gasauslässe 19, Eingangsschnittstellen 6e, 7e, 8e und Ausgangsschnittstellen 6a, 7a, 8a als "weibliches" Teil einer Steckverbindung ausgeführt sind. Dadurch können zwar Plasmamodule 1 und Abstandsbrücken zu Plasmaerzeugungsvorrichtungen 100 variabler Geometrie zusammengesteckt werden. Jedoch sind Plasmamodule 1 oder die Abstandsbrücken 11 dieser Ausführungsform nicht untereinander versteckbar. Erfindungsgemäß können Plasmaerzeugungsvorrichtungen 100 auch aus Kombinationen der Abstandsbrücken 11 und Plasmamodule 1 der Ausführungsformen gemäß Figuren 4 und 5 aufgebaut sein.

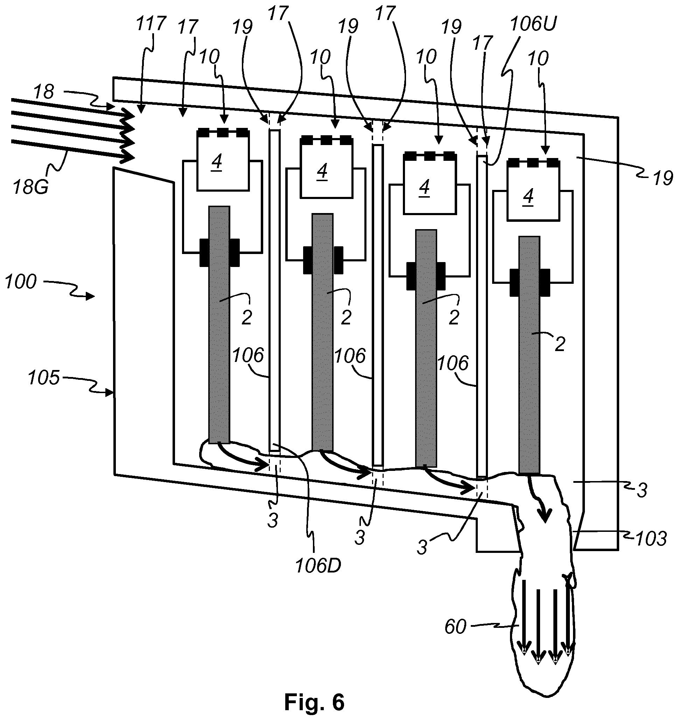

In **Figur 6** ist ein weiteres Beispiel einer Plasmaerzeugungsvorrichtung 100 schematisch dargestellt. Bei dieser Ausführungsform sind die Plasmamodule 1 in einem gemeinsamen Gehäuse 105 untergebracht. Das Gehäuse 105 weist eine gemeinsame Gaszuführung 117 auf, über die das Prozessgas 18G in das Gehäuse 105 geleitet werden kann, so dass es in einen Gaseinlass 17 eines ersten Plasmamoduls 1 mündet. Das Modulgehäuse 5 der Plasmamodule 1 wird in dieser Ausführungsform von den Wandungen des Gehäuses 105 und von im Gehäuse befindlichen Trennwänden 106 gebildet. Zwischen einem oberen Abschnitt 106U der Trennwände 106 und dem Gehäuse 105 sind jeweils Öffnungen ausgebildet, die als Gasauslass 19 bzw. Gaseinlass 17 von aufeinanderfolgenden Plasmamodulen 1 fungieren. Auch zwischen einem unteren Abschnitt 106D der Trennwände 106 und dem Gehäuse 105 sind jeweils Öffnungen ausgebildet, die als z.B. seitlich angeordnete Plasmaauslässe 3 der Plasmamodule 1 fungieren, die in das benachbarte Plasmamodul 1 einmünden. Der Plasmaauslass 3 zumindest eines Plasmamoduls 1 mündet in mindestens einen gemeinsamen Plasmaauslass 103 des Gehäuses 105. Aus diesem gemeinsamen Plasmaauslass 103 mündet ein Strahl von Plasma 60 aus dem Gehäuse 105 aus, das folglich eine höhere Intensität, Ionendichte oder Leistungsdichte haben kann als nur ein mit einem Plasmamodul 1 erzeugtes Plasma 60. Die Plasmamodule 1 sind über ihre jeweils zugeordneten Steuermodule (nicht dargestellt) gekoppelt.

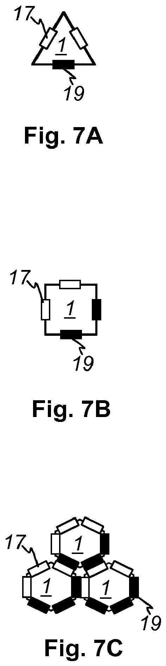

**Figur 7A, 7B und 7C** zeigen schematisch und beispielhaft mögliche polygonale Querschnittsprofile der Plasmamodule 1. Die erfindungsgemäßen Abstandsbrücken 11 können entsprechend ausgeführt sein. Im Sinne einer flexiblen Modularität ist der Querschnitt vorzugsweise als gleichseitiges Polygon ausgestaltet. Jede Seitenfläche eines Plasmamoduls 1 kann einen Gaseinlass 17 oder Gasauslass 19 tragen. Möglich ist auch, dass manche Seitenflächen der Plasmamodule 1 keinen Gaseinlass 17 oder Gasauslass 19 tragen. Ebenso kann jede Seitenfläche eines Plasmamoduls 1 eine Eingangsschnittstelle 6e, 7e, 8e oder eine Ausgangsschnittstelle 6a, 7a, 8a des Steuermoduls 20 bzw. des Konnektors 20A tragen (hier nicht dargestellt). Je geringer die Querschnittsfläche des Plasmamoduls 1 ist, desto kompakter können sie zu einer Plasmaerzeugungsvorrichtung 100 angeordnet sein, und desto höhere flächenbezogene Plasmaleistungsdichten lassen sich mit Plasmamodulen 1 mit gegebener Leistungsbegrenzung erzielen. Plasmamodule 1 und Abstandsbrücken 11 unterschiedlicher Querschnittsprofile können in einer erfindungsgemäßen Plasmaerzeugungsvorrichtung 100 kombiniert werden.

Figur 7A zeigt ein dreieckiges Querschnittsprofil, wobei das Plasmamodul 1 zwei Plasmaeinlässe 17 und einen Plasmaauslass 19 trägt. Figur 7B zeigt ein viereckiges Querschnittsprofil, das an jeweils benachbarten Seitenflächen je zwei Plasmaeinlässe 17 und zwei Plasmaauslässe 19 trägt. Figur 7C zeigt drei jeweils miteinander gekoppelte Plasmamodule 1 mit einem hexagonalen Querschnittsprofil, das an drei jeweils benachbarten Seitenflächen je drei Plasmaeinlässe 17 und drei Plasmaauslässe 19 trägt.

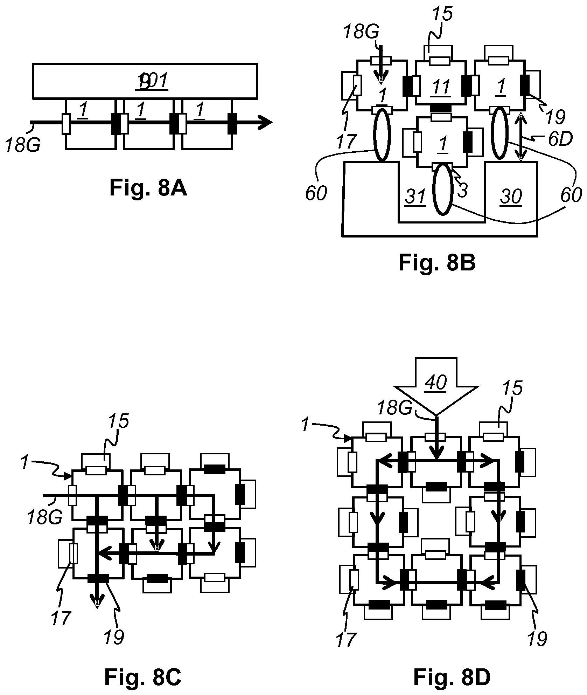

**Figur 8A bis 8D** veranschaulichen schematisch an einigen einfachen Beispielen, auf welche Art die Plasmamodule 1 zu Plasmaerzeugungsvorrichtungen 100 gekoppelt werden können. Aus Gründen der Übersichtlichkeit sind nur Plasmamodule 1 dargestellt. Prinzipiell kann zwischen jedes Plasmamodul 1 mindestens eine erfindungsgemäße Abstandsbrücke 11 eingesetzt werden. Die in den Figuren 8A bis 8D dargestellten Ausführungsformen können erfindungsgemäß kombiniert werden, um komplexere und/oder an spezielle Anwendungen angepasste Plasmaerzeugungsvorrichtungen 100 zu gestalten.

Figur 8A zeigt eine schematische Draufsicht einer Ausführungsform der Plasmaerzeugungsvorrichtung 100 mit Montageleiste 101, an der drei Plasmamodule 1 in einer Reihe miteinander gekoppelt sind. Die Plasmamodule 1 und auch die Abstandsbrücken 11 können z.B. auf einfache Weise auf die Montageleiste 101 gesteckt oder geklippst werden. Ebenso ist es möglich, dass schnell und einfach ein defektes Plasmamodul 1 ausgetauscht werden kann. Der Stillstand eines Systems, dass die Plasmamodule 1 verwendet, wird auf ein Mindestmaß beschränkt. Ebenso kann die Plasmaerzeugungsvorrichtung 100 an die verschiedensten Konfigurationen des mit dem Plasma zu behandelnden Werkstücks angepasst werden.

Figur 8B ist eine schematische Seitenansicht einer Ausführungsform einer erfindungsgemäßen Plasmaerzeugungsvorrichtung 100 in einer dreidimensionalen Bauform. Zwei Plasmamodule 1 sind über eine Abstandsbrücke 11 miteinander gekoppelt. Ein drittes Plasmamodul 1 ist an eine untere Seitenfläche der Abstandsbrücke 11 gekoppelt, so dass das dritte Plasmamodul 1 gegenüber den beiden anderen Plasmamodulen 1 nach unten abgesetzt ist. Dadurch kann beispielsweise ein mit einer Aussparung 31 versehenes Werkstück 30 in einem Prozessschritt überall mit dem gleichen Arbeitsabstand 6D (typischerweise ca. 1,5 cm) vom Plasmaauslass 3 zum Werkstück 30 mit Plasma 60 bearbeitet werden. Die Dimensionen der Plasmamodule 1 können von den Dimensionen der Abstandsbrücke 11 verschieden sein. Die Abstandsbrücke 11 kann erfindungsgemäß z.B. auch ein dreieckiges Seitenprofil haben, so dass das unten mit ihr verbundene Plasmamodul 1 unter einem anderen Winkel auf das Werkstück 30 gerichtet ist als die beiden seitlich an die Abstandsbrücke 11 angekoppelten Plasmamodule 1, um beispielsweise die vertikalen Flächen der Aussparung 31 homogener plasmabehandeln zu können.

Figur 8C zeigt eine schematische Draufsicht einer weiteren Ausführungsform einer Plasmaerzeugungsvorrichtung 100 aus zwei Reihen mit jeweils drei identischen Plasmamodulen 1. Um die obere Reihe und die untere Reihe verbinden zu können, ist das dritte Plasmamodul 1 von links in der oberen Reihe um 90° gegen den Uhrzeigersinn gedreht. Allgemein kann ein Plasmamodul 1 mit polygonalem Querschnitt in einer Winkelorientierung mit anderen Plasmamodulen 1 oder Abstandsbrücken 11 gekoppelt werden, die einem Vielfachen von 360° geteilt durch die Anzahl der Ecken seines Querschnitts entspricht. In diesem beispielhaften Ausführungsbeispiel sind alle unverbundenen Gaseinlässe 17 und Gasauslässe 19 bis auf jeweils einen mit Verschlusselementen 15 abgedichtet und alle unmittelbar benachbarten Plasmamodule 1 stehen in direkter fluider Verbindung miteinander.

Figur 8D zeigt eine schematische Draufsicht einer weiteren Ausführungsform einer Plasmaerzeugungsvorrichtung 100. Die identischen und identisch winkelorientierten Plasmamodule 1 sind entlang einer geschlossenen Kontur jeweils mit zwei anderen Plasmamodulen 1 verbunden. Ein Gaseinlass 17 ist mit einer externen Gasversorgung 40 verbunden. Alle unverbundenen Gaseinlässe 17 und Gasauslässe 19 sind mit Verschlusselementen 15 abgedichtet, so dass das Prozessgas 18G nur als Plasma 60 aus den Plasmaauslässen 3 der Plasmamodule 1 ausströmen kann.

Die Erfindung wurde unter Bezugnahme auf beispielhafte, bevorzugte Ausführungsformen beschrieben. Jedoch wird die vorliegende Erfindung nur durch die folgenden Ansprüche begrenzt.

### Bezugszeichenliste:

- 1: Plasmamodul
- 2: piezoelektrischer Transformator
- 3: Plasmaauslass
- 4: elektrischer Treiberbaustein
- 5: Modulgehäuse
- 6: Spannungsleitung
- 6e: Eingangsschnittstelle
- 6a: Ausgangsschnittstelle
- 7: Spannungsleitung
- 7e: Eingangsschnittstelle
- 7a: Ausgangsschnittstelle
- 8: Steuerleitung
- 8e: Eingangsschnittstelle
- 8a: Ausgangsschnittstelle
- 11: Abstandsbrücke
- 15: Verschlusselement
- 17: Gaseinlass
- 18: Gasversorgungskanal
- 18G: Prozessgas
- 19: Gasauslass
- 20: Steuermodul
- 20A: Konnektor
- 21, 22: primärseitige Elektroden
- 23: sekundärseitige Elektrode
- 24: Steuerbus
- 30: Werkstück
- 40: externe Gasversorgung
- 60: Plasma
- 100: Plasmaerzeugungsvorrichtung
- 101: Montageleiste
- 103: gemeinsamer Plasmaauslass
- 105: Gehäuse
- 106: Trennwand
- 106U: oberer Abschnitt
- 106L: unterer Abschnitt
- 117: gemeinsamer Gaseinlass

## Patentansprüche

1. Plasmaerzeugungsvorrichtung (100) zur Erzeugung eines Plasmas (60) mit wenigstens zwei Plasmamodulen (1), wobei jedes Plasmamodul (1) ein Modulgehäuse (5) hat, das zur Zuführung eines Prozessgases (18G) mindestens einen Gaseinlass (17) aufweist, eine Entladungseinrichtung (4, 2) im Modulgehäuse (5) zur Erzeugung des Plasmas (60) aus dem Prozessgas (18G) vorgesehen hat und einen Plasmaauslass (3) ausgebildet hat, wobei ferner jedes Plasmamodul (1) mindestens einen Gasauslass (19) für einen Teil des Prozessgases (18G) aufweist,
**dadurch gekennzeichnet,**
**dass** die Entladungseinrichtung (4, 2) einen steuerbaren elektrischen Treiberbaustein (4) aufweist, der zur Erzeugung des Plasmas (60) mittels Entladungen im Normaldruckbereich elektrisch mit einem piezoelektrischen Transformator (2) verbunden ist;
**dass** jedes Plasmamodul (1) ein Steuermodul (20) umfasst, das jeweils eine Steuerleitung (8) und mindestens eine Spannungsleitung (6, 7) aufweist, die mit dem jeweiligen Treiberbaustein (4) elektrisch verbunden sind, wobei das Steuermodul (20) jeweils mindestens eine Eingangsschnittstelle (6e, 7e, 8e) und mindestens eine Ausgangsschnittstelle (6a, 7a, 8a) trägt; und
**dass** eine Abstandsbrücke (11), die einen Konnektor (20A) und mindestens einen Gaseinlass (17) und mindestens einen Gasauslass (19) besitzt, mindestens zwei aufeinanderfolgende Plasmamodule (1) derart miteinander verbindet, dass der Konnektor (20A) der Abstandsbrücke (11) die Steuermodule (20) der Plasmamodule (1) derart miteinander verbindet, dass mindestens eine Ausgangsschnittstelle (6a, 7a, 8a) des Steuermoduls (20) eines Plasmamoduls (1) mit je mindestens einer Eingangsschnittstelle (6e, 7e, 8e) des Steuermoduls (20) eines verbundenen Plasmamoduls (1) elektrisch verbunden ist, so dass die verbundenen Steuerleitungen (8) der Steuermodule (20) einen gemeinsamen Steuerbus (24) der gekoppelten Plasmamodule (1) bilden, und dass mindestens ein Gasauslass (19) eines Plasmamoduls mit einem Gaseinlass (17) der Abstandsbrücke (11) und ein Gasauslass (19) der Abstandsbrücke (11) mit einem Gaseinlass (17) eines weiteren Plasmamoduls (1) in fluider Verbindung steht, wobei die Plasmamodule (1) und die Abstandsbrücke (11) steckbar miteinander verbunden sind, so dass eine form- und/oder kraftschlüssige Verbindung entsteht.

2. Plasmaerzeugungsvorrichtung (100) nach Anspruch 1, wobei zumindest ein Gasauslass (19) oder ein Gaseinlass (17) eines Plasmamoduls (1), der nicht mit einem Gaseinlass (17) respektive einem Gasauslass (19) eines weiteren Plasmamoduls (1) oder einer Abstandsbrücke (11) verbunden ist, mit einem Verschlusselement (15) verschlossen ist.

3. Plasmaerzeugungsvorrichtung (100) nach Anspruch 1 oder 2, wobei die verbundenen Plasmamodule (1) in einer ein-, zwei- oder dreidimensionalen Art angeordnet sind.

4. Plasmaerzeugungsvorrichtung (100) nach einem der Ansprüche 1 bis 3, wobei die Plasmamodule (1) oder die Plasmamodule (1) und die Abstandsbrücken (11) an einer gemeinsamen Montageleiste (101) lösbar angebracht sind.

5. Plasmaerzeugungsvorrichtung (100) nach Ansprüchen 1 bis 4, wobei alle Plasmamodule (1) der Plasmaerzeugungsvorrichtung (100) von einem gemeinsamen Gehäuse (105) umgeben sind.

6. Plasmaerzeugungsvorrichtung (100) nach Anspruch 5, wobei der Plasmaauslass (3) der Plasmamodule (1) aus dem Gehäuse (105) über einen gemeinsamen Plasmaauslass (103) ausmündet oder in ein verbundenes Plasmamodul (1) einmündet.

7. Plasmaerzeugungsvorrichtung (100) nach einem der Ansprüche 1 bis 6, wobei jedes Plasmamodul (1) der Plasmaerzeugungsvorrichtung (100) ein Modulgehäuse (5), mindestens einen Gaseinlass (17) zur Zuführung eines Prozessgases (18G), eine Entladungseinrichtung (4, 2) im Modulgehäuse (5) zur Erzeugung des Plasmas (60) aus dem Prozessgas (18G), einen Plasmaauslass (3) und mindestens einen Gasauslass (19) für einen Teil des Prozessgases (18G) vorgesehen hat.

8. Plasmaerzeugungsvorrichtung (100) nach Anspruch 7, wobei ein Steuermodul (20) dem Modulgehäuse (5) zugeordnet ist, das eine Steuerleitung (8) und mindestens eine Spannungsleitung (6, 7) aufweist, die mit dem Treiberbaustein (4) elektrisch verbunden sind, und wobei das Steuermodul (20) mindestens eine Ausgangsschnittstelle (6a, 7a, 8a) und mindestens eine Eingangsschnittstelle (6e, 7e, 8e) ausgebildet hat.

## Claims

1. A plasma generation apparatus (100) for generating a plasma (60), with
at least two plasma modules (1), with each plasma module (1) comprising a module housing (5) equipped with at least one gas inlet (17) for feeding a process gas (18G), a discharge device (4, 2) provided in the module housing (5) for generating the plasma (60) from the process gas (18G), and a plasma outlet (3), with each plasma module (1) further having at least one gas outlet (19) for a part of the process gas (18G),
**characterized in that**
the discharge device (4, 2) is provided with a controllable electric driver component (4), which, for generating the plasma (60) by means of discharges in the standard pressure range, is electrically connected with a piezoelectric transformer (2); and
that each plasma module (1) comprises a control module (20), which is provided with a control line (8) and at least one voltage line (6, 7) each, which are electrically connected to the respective driver component (4), with the control module (20) having at least one input interface (6e, 7e, 8e) each and at least one output interface (6a, 7a, 8a) each; and
that a spacing bridge (11), provided with a connector (20A), at least one gas inlet (17) and at least one gas outlet (19), connects at least two successive plasma modules (1) with each other such that the connector (20A) of the spacing bridge (11) connects the control modules (20) of the plasma modules (1) with each other such that at least one output interface (6a, 7a, 8a) of the control module (20) of a plasma module (1) is electrically connected to at least one input interface (6e, 7e, 8e) each of the control module (20) of a connected plasma module (1), so that the connected control lines (8) of the control modules (20) form a common control bus (24) of the coupled plasma modules (1), and at least one gas outlet (19) of a plasma module (1) is in fluid connection with a gas inlet (17) of the spacing bridge (11) and a gas outlet (19) of the spacing bridge (11) is in fluid connection with a gas inlet (17) of a further plasma module (1), with the plasma modules (1) and the spacing bridge (11) being connected in a plug-in fashion to form a positive and/or frictional connection.

2. The plasma generation apparatus (100) as claimed in claim 1, wherein at least one gas outlet (19) or one gas inlet (17) of a plasma module (1), that is not connected with a gas inlet (17) or a gas outlet (19), respectively, of a further plasma module (1) or a spacing bridge (11), is closed by means of a closing element (15).

3. The plasma generation apparatus (100) as claimed in claim 1 or 2, wherein the connected plasma modules (1) are arranged in a one-, two- or three-dimensional fashion.

4. The plasma generation apparatus (100) as claimed in any of claims 1 to 3, wherein the plasma modules, (1) or the plasma modules (1) and the spacing bridges (11), are detachably affixed to a common mounting strip (101).

5. The plasma generation apparatus (100) as claimed in claims 1 to 4, wherein all plasma modules (1) of the plasma generation apparatus (100) are enclosed in a common housing (105).

6. The plasma generation apparatus (100) as claimed in claim 5, wherein the plasma outlet (3) of the plasma modules (1) leads out of the housing (105) via a common plasma outlet (103) or leads into a connected plasma module (1).

7. The plasma generation apparatus (100) as claimed in any of claims 1 to 6, wherein each plasma module (1) of the plasma generation apparatus (100) is provided with a module housing (5), at least one gas inlet (17) for feeding a process gas (18G), a discharge device (4, 2) in the module housing (5) for generating the plasma (60) from the process gas (18G), a plasma outlet (3) and at least one gas outlet (19) for a part of the process gas (18G).

8. The plasma generation apparatus (100) as claimed in claim 7, wherein a control module (20) is assigned to the module housing (5) that is provided with a control line (8) and at least one voltage line (6, 7), these lines being electrically connected to the driver component (4), and wherein the control module (20) is configured to have at least one output interface (6a, 7a, 8a) and at least one input interface (6e, 7e, 8e).

## Revendications

1. Dispositif de génération de plasma (100) pour générer un plasma (60), doté
d'au moins deux modules de plasma (1), chaque module de plasma (1) ayant un boîtier modulaire (5) qui présente, pour l'alimentation en gaz de process (18G), au moins une entrée de gaz (17), un moyen de décharge (4, 2) étant prévu dans le boîtier modulaire (5) pour générer le plasma (60) à partir du gaz de process (18G) et une sortie de plasma (3) étant conçue, chaque module de plasma (1) présentant de plus au moins une sortie de gaz (19) pour une partie du gaz de process (18G),
**caractérisé en ce que**
le moyen de décharge (4, 2) présente un élément de pilotage électrique commandable (4) qui est connecté électriquement à un
transformateur piézoélectrique (2) pour la génération du plasma (60) au moyen de décharges sous pression normalisée,
chaque module de plasma (1) comprend un module de commande (20) qui présente respectivement une conduite de commande (8) et au moins une conduite de tension (6, 7), lesquelles sont connectées électriquement à l'élément de pilotage (4) correspondant, le module de commande (20) portant respectivement au moins une interface d'entrée (6e, 7e, 8e) et au moins une interface de sortie (6a, 7a, 8a), et
un pont espaceur (11) qui possède un connecteur (20A) et au moins une entrée de gaz (17) et au moins une sortie de gaz (19), et qui relie l'un à l'autre au moins deux modules de plasma (1) consécutifs, de telle sorte que le connecteur (20A) du pont espaceur (11) relie l'un à l'autre les modules de commande (20) des modules de plasma (1), de telle sorte qu'au moins une interface de sortie (6a, 7a, 8a) du module de commande (20) d'un module de plasma (1) est connectée électriquement à au moins une interface d'entrée (6e, 7e, 8e) du module de commande (20) d'un module de plasma (1) connecté, de telle sorte que les conduites de commande (8) connectées des modules de commande (20) forment un bus de commandes commun (24) des modules de plasma (1) couplés, et qu'au moins une sortie de gaz (19) d'un module de plasma (1) est en liaison fluide avec une entrée de gaz (17) du pont espaceur (11), et une sortie de gaz (19) du pont espaceur (11) avec une entrée de gaz (17) d'un autre module de plasma (1), les modules de plasma (1) et le pont espaceur (11) étant connectés encartables l'un à l'autre de telle sorte à créer une solidarisation par accouplement mécanique et/ou par force.

2. Dispositif de génération de plasma (100) selon la revendication 1, au moins une sortie de gaz (19) ou une entrée de gaz (17) d'un module de plasma (1), qui n'est pas reliée à une entrée de gaz (17) ou à une sortie de gaz (19) d'un autre module de plasma (1) ou d'un pont espaceur (11), étant obturée par un élément obturateur (15).

3. Dispositif de génération de plasma (100) selon la revendication 1 ou 2, les modules de plasma connectés étant agencés de manière unidimensionnelle, bidimensionnelle ou tridimensionnelle.

4. Dispositif de génération de plasma (100) selon l'une quelconque des revendications 1 à 3, les modules de plasma (1) ou les modules de plasma (1) et les ponts espaceurs (11) étant montés détachables sur une barrette de montage commune (101).

5. Dispositif de génération de plasma (100) selon les revendications 1 à 4, tous les modules de plasma (1) du dispositif de génération de plasma (100) étant entourés d'un boîtier commun (105).

6. Dispositif de génération de plasma (100) selon la revendication 5, la sortie de plasma (3) des modules de plasma (1) se déversant à l'extérieur du boîtier (105) par une sortie de plasma (103) commune ou débouchant dans un module de plasma (1) relié.

7. Dispositif de génération de plasma (100) selon l'une quelconque des revendications 1 à 6, chaque module de plasma (1) du dispositif de génération de plasma (100) ayant prévu un boîtier modulaire (5), au moins une entrée de gaz (17) pour l'alimentation un gaz de process (18G), un moyen de décharge (4, 2) dans le boîtier modulaire (5) pour générer le plasma (60) à partir du gaz de process (18G), une sortie de plasma (3) et au moins une sortie de gaz (19) pour une partie du gaz de process (18G).

8. Dispositif de génération de plasma (100) selon la revendication 7, un module de commande (20) étant attribué au boîtier modulaire (5) qui présente une conduite de commande (8) et au moins une conduite de tension (6, 7), lesquelles sont en connexion électrique avec l'élément de pilotage (4), et le module de commande (20) formant au moins une interface de sortie (6a, 7a, 8a) et au moins une interface d'entrée (6e, 7e, 8e).
